# EUROPEAN PATENT SPECIFICATION

(11) **EP 0 609 804 B1**
(45) Date of publication and mention of the grant of the patent: **20.10.1999**
(21) Application number: 94101383.1
(22) Date of filing: 31.01.1994
(51) Int. Cl.: H01L 39/24

(54) **Method of preparing a Nb3X superconducting wire**
Verfahren zur Herstellung eines Nb3X supraleitenden Drahtes
Procédé de fabrication d'un fil supraconducteur de type Nb3X

(30) Priority: 02.02.1993 JP 1540493
(43) Date of publication of application: 10.08.1994
(73) Proprietor: SUMITOMO ELECTRIC INDUSTRIES, LIMITED, Osaka 541 (JP)
(72) Inventor: Yamada, Yuichi, c/o Osaka Works of Sumitomo, Konohana-ku, Osaka-shi (JP); Ayai, Naoki, c/o Osaka Works of Sumitomo, Konohana-ku, Osaka-shi (JP)
(74) Representative: Winter, Brandl, Fürniss, Hübner, Röss, Kaiser, Polte, Kindermann Partnerschaft

(56) References cited:
- EP-A- 0 124 708
- EP-A- 0 405 405
- FR-A- 2 265 159
- PATENT ABSTRACTS OF JAPAN vol. 16, no. 392 (E-1251)20 August 1992 & JP-A-04 129 108 (SUMITOMO ELECTRIC INDUSTRIES,LTD) 30 April 1992
- PATENT ABSTRACTS OF JAPAN vol. 016, no. 397 (E-1252)24 August 1992 & JP-A-04 132 118 (SUMITOMO ELECTRIC IND LTD) 6 May 1992
- PATENT ABSTRACTS OF JAPAN vol. 016, no. 392 (E-1251)20 August 1992 & JP-A-04 129 107 (SUMITOMO ELECTRIC IND LTD) 30 April 1992
- PATENT ABSTRACTS OF JAPAN vol. 014, no. 444 (E-0982)21 September 1990 & JP-A-02 177 217 (SHOWA ELECTRIC WIRE & CABLE CO LTD) 10 July 1990

## Description

### BACKGROUND OF THE INVENTION

### Field of the Invention

The present invention relates to a method of preparing Nb₃X superconducting wires, such as Nb₃X superconducting wires which are employed as high magnetic field superconducting materials such as superconducting magnets for a nuclear fusion reactor or the like.

### Description of the Background Art

In general, an Nb₃X superconducting material such as Nb₃Al, Nb₃Sn or Nb₃Ge is expected as a superconducting material since the same is applicable to a high magnetic field use, which cannot be satisfied by an alloy superconducting material such as NbTi. In particular, an Nb₃Al superconducting material is expected as a useful superconducting material for a nuclear fusion reactor which receives high magnetic force in a high magnetic field, or a superconducting material for power storage, due to a high critical current and excellent stress-strain effect in a high magnetic field. See for example EP-A-0 405 405 disclosing a multifilament superconducting wire of Nb₃Al suitable for nuclear fusion reactors.

In general, it is difficult to plastically work such an Nb₃X superconducting material, which is extremely hard and brittle as compared with an alloy superconducting material such as NbTi. Thus, various studies have generally been made on a method of preparing such an Nb₃X superconducting material, for example in Advances in Cryogenic Engineering, IGMG 32 (1986).

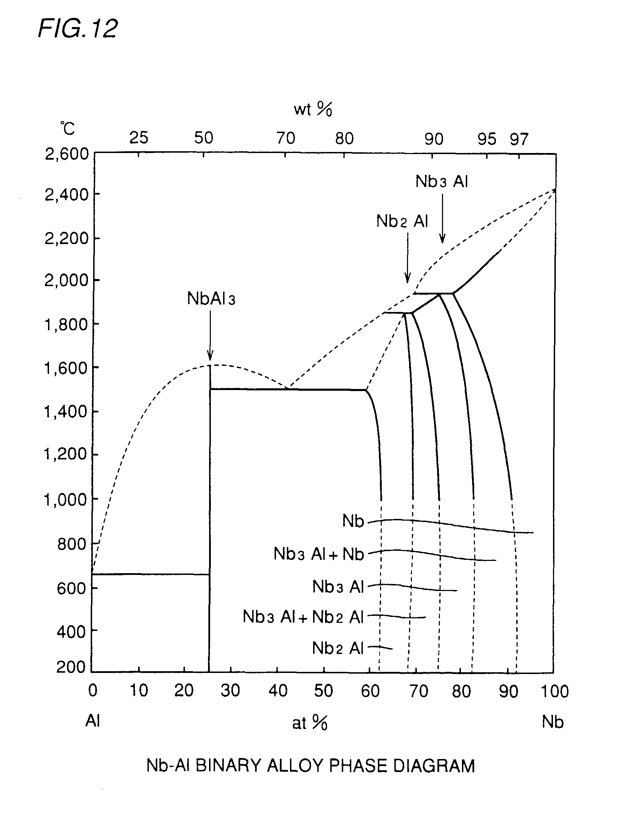

Fig. 12 is an Nb-Al binary alloy phase diagram.

Referring to Fig. 12, Nb₃Al stably exists under a high temperature of at least 1600°C with a stoichiometric composition ratio of Nb to Al of 3:1. Under a low temperature of less than 1600°C, however, the Nb₃Al is formed with mixture of Nb₂Al, which is a non-superconducting material. Therefore, an Nb₃Al compound superconducting material which is prepared at a low temperature of less than 1600°C has a low critical temperature, a low critical magnetic field (Hc) and a low critical current density (Jc) in general. Thus, no method of preparing an Nb₃Al superconducting material has been put into practice although there has been studied a quenching method of cooling the material from a high temperature of at least 1600°C in a short time or the like.

However, it has recently been recognized that excellent Nb₃Al is formed in a portion having a short diffusion length of Al atoms in an Nb layer and/or a portion having a short diffusion length of Nb atoms in an Al layer, even if the temperature is not more than 1000°C. To this end, there have been developed production methods such as powder metallurgy (PM), a tube method, composite working such as clad chip extrusion, and a jelly roll method. Every one of these methods is adapted to mix pure Nb or a material containing Nb with pure Al or a material containing Al in an extremely fine state, and can increase the aforementioned portion having a short diffusion length. According to such a method, therefore, it is possible to obtain a high-performance Nb₃Al superconducting material having a stoichiometric composition ratio of Nb to Al which is close to 3:1, with a high critical temperature, a high critical magnetic field (Hc) and a high critical current density (Jc).

Among the aforementioned preparation methods, the jelly roll method can advantageously prepare a superconducting wire having a multifilamentary structure, compose a stabilizing material, and easily prepare a long material. Thus, this is the most practicable method of preparing an Nb₃Al superconducting wire.

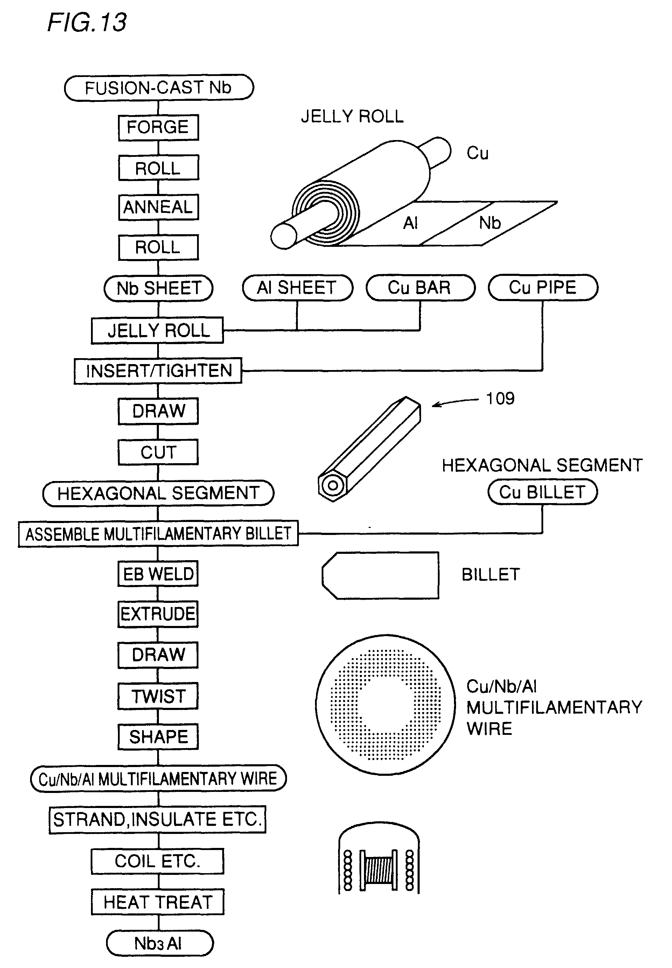

The jelly roll method is now described with reference to Fig. 13.

Fig. 13 is a process drawing showing a method of preparing an Nb₃Al superconducting multifilamentary wire in accordance with the jelly roll method.

Referring to Fig. 13, a high-purity Nb sheet and a high-purity Al sheet are first prepared by melting and rolling. Then, the Nb sheet and the Al sheet are superposed with each other and wound on an oxygen free copper rod, to prepare a wire (jelly roll). Then, this wire is inserted in an oxygen free copper pipe and drawn into a hexagonal shape in section, and thereafter cut into a desired length to prepare a hexagonal segment 109. Then, a plurality of such hexagonal segments 109 are filled in a copper pipe to prepare a billet, which in turn is sealed up in a vacuum by electron beam welding, and subjected to extrusion. Then, the as-formed multifilamentary wire is drawn and twisted, shaped, stranded and insulated at desire, coiled and thereafter heat treated to form a superconducting phase (A15 structure of Nb₃Al). The aforementioned jelly roll method is described in more detail in Sumitomo Denki, No. 139, September 1991, pp. 93 - 100.

In order to form Nb₃X having excellent superconductivity by such a jelly roll method as disclosed in Patent Abstracts of Japan, vol. 16, no. 392 (E-1251), 20.8.92 and JP-A-04 132 118, it is necessary to maximize the amount of working such as drawing for reducing the sectional area and reduce first and second sheets in thickness, for increasing the amount of the aforementioned portion having a short diffusion length.

When the sectional area of the wire is reduced by drawing or the like, however, the wire is inhomogeneously deformed by differences in tensile strength (N/mm²), ductility, toughness, brittleness and work-hardenability between the first sheet, the second sheet and a Cu matrix which is employed as a stabilizing material, leading to damage or breakage.

In other words, the conventional jelly roll method has such a problem that it is necessary to increase the amount of working such as drawing for reducing the sectional area in order to improve superconductivity such as the critical current density (Jc), while such increase of the amount of working may result in a high possibility of damage or breakage of the wire.

### SUMMARY OF THE INVENTION

An object of the present invention is to provide method of preparing a Nb₃X superconducting wire and an Nb₃X superconducting wire of excellent characteristics having higher critical current densities (Jc) etc. as compared with a conventional Nb₃X superconducting wire with no particular increase in amounts of working such as drawing for reducing sectional areas.

This objects are solved with a method as defined in claim 1.

Provided according to the present invention is a wire which is obtained by superposing and winding up a first heat-treated sheet consisting of pure Nb or an Nb alloy and a second sheet consisting of metal atoms X reacting with the Nb for forming a compound exhibiting superconductivity, or an alloy containing the metal atoms X. This wire is characterized in that the eventual interface between the first and second sheets is densely zigzagged to increase the contact area therebetween.

In accordance with one aspect of the present invention, a Nb₃X superconducting wire is obtained. A plurality of such wires are embedded in a matrix as filaments, thereby providing a Nb₃X superconducting multifilamentary wire. Further, such wires for superconducting wires are heat treated to provide an Nb₃X superconducting wire and an Nb₃X superconducting multifilamentary wire.

Preferably, the metal atoms X are prepared from a metal which is selected from Al, Sn and Ge. On the other hand, the Nb which is contained in the first sheet is preferably at least 99.0 % in purity.

In accordance with another aspect of the present invention, a method of preparing a Nb₃X superconducting wire is provided. This method comprises a step of preparing a first sheet consisting of pure Nb or an Nb alloy by melting and rolling, a step of heat treating said first sheet consisting of pure Nb or an Nb alloy, a step of superposing the heat-treated first sheet with a second sheet consisting of metal atoms X reacting with the Nb and forming a compound exhibiting superconductivity or an alloy containing the metal atoms X and winding up these sheets for preparing a wire, and a step of performing working on the wire for reducing its sectional area.

A method of preparing a Nb₃X superconducting multifilamentary wire is provided by further comprising a step of bundling a plurality of the aforementioned wires and charging the same in a cylindrical member, and a step of performing working on the cylindrical member which is charged with the wires for further reducing its sectional area thereby preparing a multifilamentary wire. Further, methods of preparing an Nb₃X superconducting wire and an Nb₃X superconducting multifilamentary wire are provided by further comprising steps of heat treating the as-worked wires.

The step of heat treating the first sheet is preferably carried out in and for a temperature range and a time which are sufficient for readjusting the crystal structure of the first sheet and irregularizing crystal orientations. Further, the step of heat treating the first sheet is preferably carried out in a temperature range of 700 to 1100°C for 1 to 10 hours.

The working for reducing the sectional area of the wire or the like is implemented by drawing, wire drawing, forging, rolling or the like, for example.

In the Nb₃X superconducting wire according to the present invention, the eventual interface between the first and second sheets is densely zigzagged to increase the contact area between the first and second sheets which are superposed and wound up.

In general, high-quality Nb₃X containing Nb and X in a composition ratio of 3:1 is formed in the vicinity of the interface between the first and second sheets by a diffusion reaction (heat treatment). According to the present invention, the amount of formation of high-quality Nb₃X is increased in the heat treatment since the contact area between the first and second sheets is increased.

In the superconducting wire according to the present invention, the interface between the first and second sheets is densely zigzagged, whereby the aforementioned portion having a short diffusion length is increased. Therefore, the metal atoms X and Nb atoms are improved in diffusibility, whereby the amount of Nb₃X which is formed by the heat treatment per unit time is increased as compared with the prior art. Thus, it is possible to obtain an Nb₃X superconducting wire having a higher critical current density (Jc) as compared with the prior art.

In the Nb₃X superconducting wire according to the present invention, further, the contact area between the first and second sheets is so increased that a prescribed amount of Nb₃X can be formed by a diffusion reaction (heat treatment) in a shorter time as compared with the prior art. The mean grain size of Nb₃X phase crystals formed in such a short time is refined as compared with that of crystals formed in a long time, whereby pinning is increased.

The term "pinning" indicates immovable fixation of magnetic flux. When there are a current and a magnetic field, electromagnetic force which is supplied by the product of a current density and a magnetic flux density is applied to magnetic flux. When the electromagnetic force exceeds pinning force, the magnetic flux starts to move for generating a voltage. Thus, a current density in a competitive state of the pinning force and the electromagnetic force can be regarded as the critical current density in the magnetic field. The magnetic flux is conceivably pinned by a lattice defect or a grain boundary, and a high critical current density (Jc) is obtained when Nb₃X is disposed in a fine grain state, since pinning is increased.

Namely, the Nb₃X superconducting wire according to the present invention can form Nb₃X grains having a smaller mean grain size as compared with the prior art, as hereinabove described. Consequently, pinning is increased and the inventive Nb₃X superconducting wire exhibits a high critical current density (Jc).

In the a Nb₃X superconducting wire according to the present invention, further, the interface between the first and second sheets is zigzagged. In other words, both of the first and second sheets are partially reduced in thickness. Thus, it is not necessary to reduce the overall first and second sheets in thickness by increasing the amount of working for reducing the sectional area dissimilarly to the prior art, whereby damage and breakage of the wire are extremely reduced.

According to the present invention, further, the interface between the first and second sheets is zigzagged by employment of the heat-treated first sheet. Namely, the first sheet is readjusted in crystal structure by the heat treatment, so that crystal orientations are irregularized. The heat-treated first sheet is superposed with the second sheet, wound up and subjected to working for reducing the sectional area, whereby the direction of a sliding surface of the first sheet is irregularized during the working to zigzag the interface between the first and second sheets.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective view schematically showing a first step of preparing an Nb₃Al superconducting wire according to Example of the present invention;
Fig. 2 is a sectional view schematically showing a wire prepared in the step shown in Fig. 1;
Fig. 3 is a perspective view schematically showing a second step of preparing an Nb₃Al superconducting wire according to Example of the present invention;
Fig. 4 is a perspective view schematically showing a third step of preparing an Nb₃Al superconducting wire according to Example of the present invention;
Fig. 5 is a perspective view schematically showing a fourth step of preparing an Nb₃Al superconducting wire according to Example of the present invention;
Fig. 6 is a sectional view schematically showing a Nb₃Al superconducting multifilamentary wire according to Example of the present invention;
Fig. 7 is an enlarged sectional view schematically illustrating a wire of the multifilamentary wire shown in Fig. 6;
Fig. 8 is a sectional view schematically showing a Nb₃Al superconducting multifilamentary wire according to comparative example;
Fig. 9 is an enlarged sectional view schematically illustrating a wire of the multifilamentary wire shown in Fig. 8;
Fig. 10 is a sectional view showing a wire for an Nb₃Al superconducting multifilamentary wire according to another conventional example;
Fig. 11 is an enlarged sectional view schematically illustrating a wire of the multifilamentary wire shown in Fig. 10;
Fig. 12 is an Nb-Al binary alloy phase diagram; and
Fig. 13 is a process drawing schematically showing a conventional method of preparing an Nb₃Al superconducting multifilamentary wire according to a jelly roll method.

### DESCRIPTION OF THE PREFERRED EMBODIMENTS

### (Example 1)

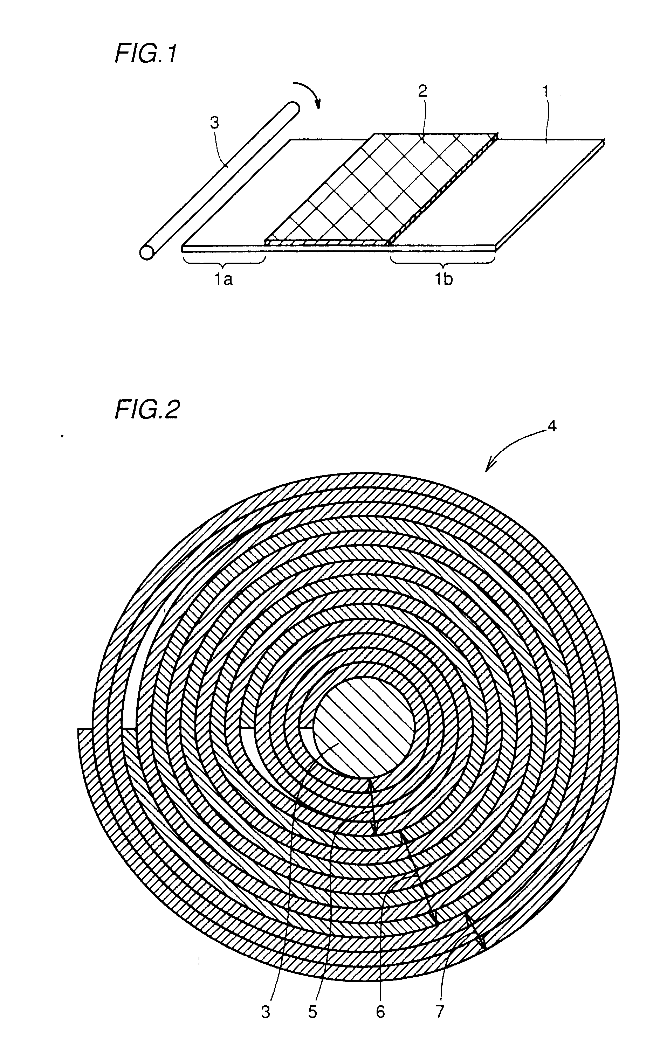

Figs. 1 to 7 are diagrams for illustrating a method of preparing an Nb₃Al superconducting multifilamentary wire according to Example of the present invention.

Referring to Fig. 1, a Nb sheet 1, consisting of Nb foil of 0.18 mm in thickness, 300 mm in width and 800 mm in length, was first prepared by melting and rolling. This Nb sheet 1 was maintained in a temperature range of 700 to 900°C for about 2 hours, and thereafter cooled to the room temperature by a heat treatment (the so-called annealing).

Then, an Al sheet 2, consisting of Al foil of 0.05 mm in thickness, 300 mm in width and 500 mm in length, was superposed on the surface of the heat treated Nb sheet 1. At this time, both end portions 1a and 1b of the Nb sheet 1 were not superposed with the Al sheet 2.

Then, the sheets 1 and 2 were wound on a copper rod 3 of 3 mm in diameter and 400 mm in length, from the end portion 1a of the Nb sheet 1. Namely, the end portion 1a of the Nb sheet 1 was first wound on the copper bar 3 by four turns, then the superposed portions of the Nb sheets 1 and the Al sheets 2 were wound thereon and finally the other end portion 1b was wound thereon, to prepare a wire (the so-called jelly roll portion) 4. Thereafter excess parts were removed from both end portions of the copper bar 3 by 100 mm in total.

Fig. 2 is a sectional view schematically showing the wire 4 as obtained.

Referring to Fig. 2, this wire 4 was made up by a first diffusion barrier layer 5 which was formed around the centrally located copper bar 3, a laminate portion 6 which was formed around the first diffusion barrier layer 5, and a second diffusion barrier layer 7 which was formed around the laminate portion 6. The first diffusion barrier layer 5 was formed by the end portion 1a of the Nb sheet 1, which was wound by four turns. In the laminate portion 6, on the other hand, the Nb sheets 1 and the Al sheets 2 were wound up in an alternately superposed state. Further, the second diffusion barrier layer 7 was formed by the end portion 1b of the Nb sheet 1, which was wound by a plurality of turns.

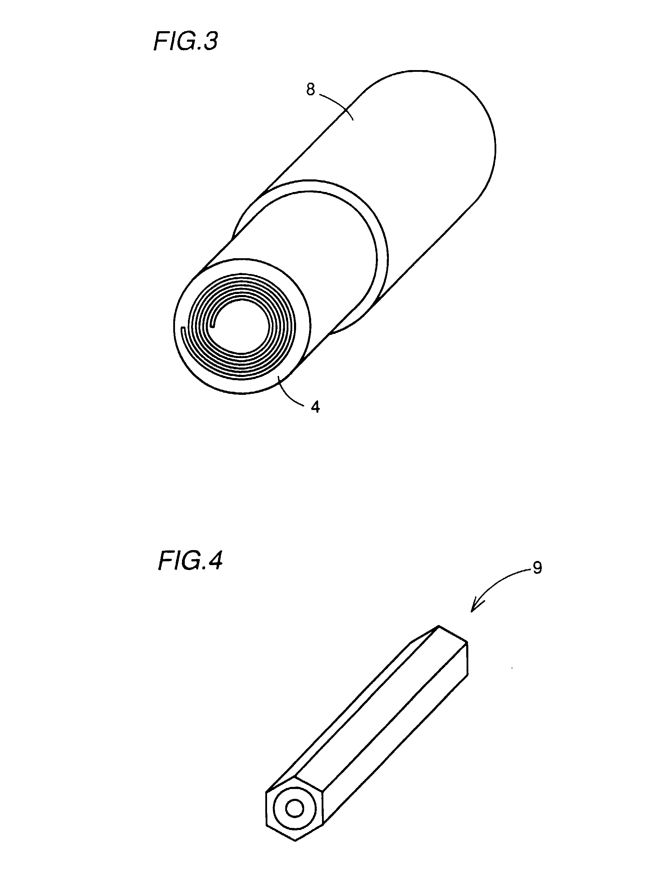

Referring to Fig. 3, this wire 4 was inserted in a copper pipe 8 of 19 mm in outer diameter and 16 mm in inner diameter, and thereafter drawn to prepare a hexagonal segment 9.

Fig. 4 is a perspective view showing the hexagonal segment 9 as obtained.

Referring to Fig. 4, this hexagonal segment 9 had a hexagonal section, with a flat-to-flat distance of 2 mm and a length of 200 mm.

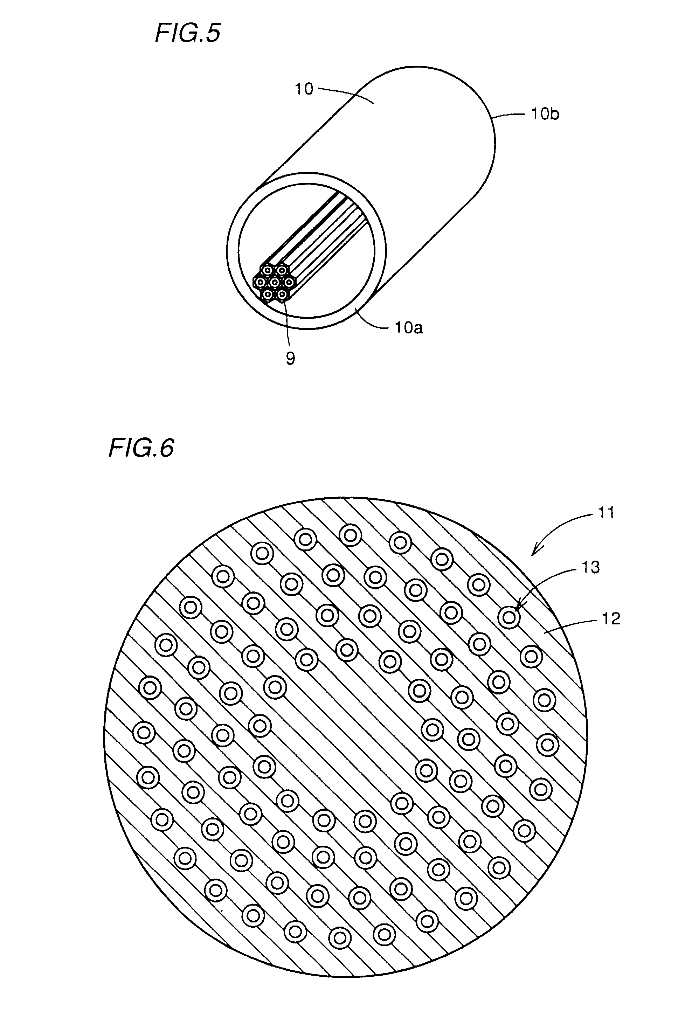

Referring to Fig. 5, about 800 such hexagonal segments 9 were charged in a copper pipe 10 of 70 mm in outer diameter and 68 mm in inner diameter, and thereafter both ends 10a and 10b of the copper pipe 10 were closed with copper covers (not shown) and sealed by electron beam welding, to prepare a billet (not shown). Then, this billet was extruded and repeatedly drawn to prepare a wire 11 of 1 mm in diameter.

Fig. 6 is a sectional view schematically showing the wire 11 as obtained.

Referring to Fig. 6, this wire 11 was formed by a matrix (stabilizing material) 12 of Cu and a number of wires 13 consisting of Nb, Al and Cu, which were embedded therein.

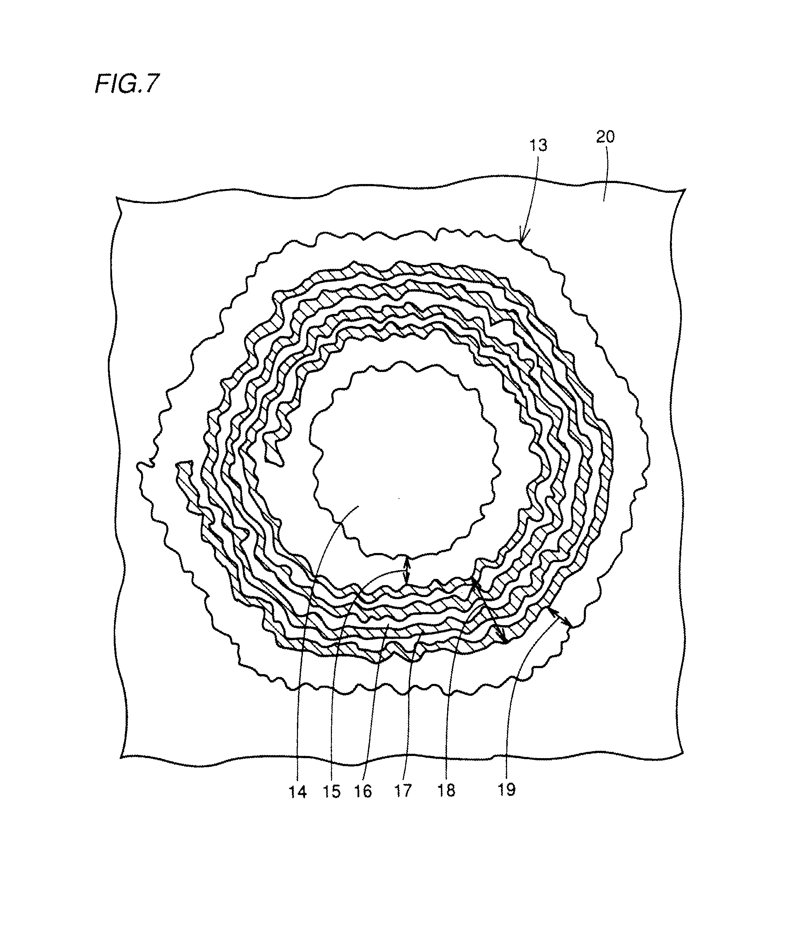

Fig. 7 is a model diagram of a microphotograph of 40 or 80 magnifications showing a section of each wire 13.

Referring to Fig. 7, the wire 13 was made up by a first diffusion barrier layer 15 containing Nb, which was formed to enclose the outer surface of a centrally located copper matrix (stabilizing material) 14, a laminate portion 18 which was formed to enclose the first diffusion barrier layer 15, and a second diffusion barrier layer 19 containing Nb, which was formed to enclose the laminate portion 18. Further, another copper matrix (stabilizing material) 20 was formed around the wire 13, to enclose the outer surface of the second diffusion barrier layer 19.

In this wire 13, Nb containing layers 16 and Al containing layers 17 were alternately spirally formed in the laminate portion 18. The interface between the Nb containing layers 16 and the Al containing layers 17 was densely zigzagged to increase the contact area between the Nb containing layers 16 and the Al containing layers 17. Further, both of the interfaces between the first diffusion barrier layer 15 and the copper matrix 14 and between the second diffusion barrier layer 19 and the copper matrix 20 were also zigzagged.

### (Example 2)

The wire 11 of 1 mm in diameter obtained in Example 1 was further drawn to prepare a wire of 0.6 mm in diameter.

The wire as obtained had a structure which was similar to that of Example 1 shown in Fig. 7. However, Nb containing layers 16 and Al containing layers 17 were smaller in thickness than those of the wire according to Example 1 as a whole, since the amount of drawing was larger than that in Example 1.

### (Comparative Example 1)

For the purpose of comparison, a wire 21 of 1 mm in diameter was prepared from a Nb containing sheet, which was not heat treated. Other conditions were absolutely similar to those in Example 1, and hence redundant description is omitted.

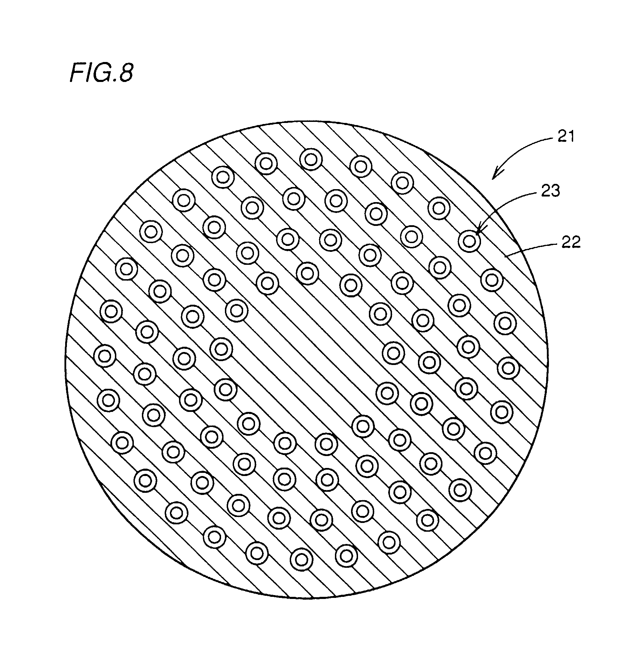

Fig. 8 is a sectional view schematically showing the wire 21 as obtained.

Referring to Fig. 8, this wire 21 was formed by a matrix (stabilizing material) 22 of Cu and a number of wires 23 consisting of Nb, Al and Cu, which were embedded therein.

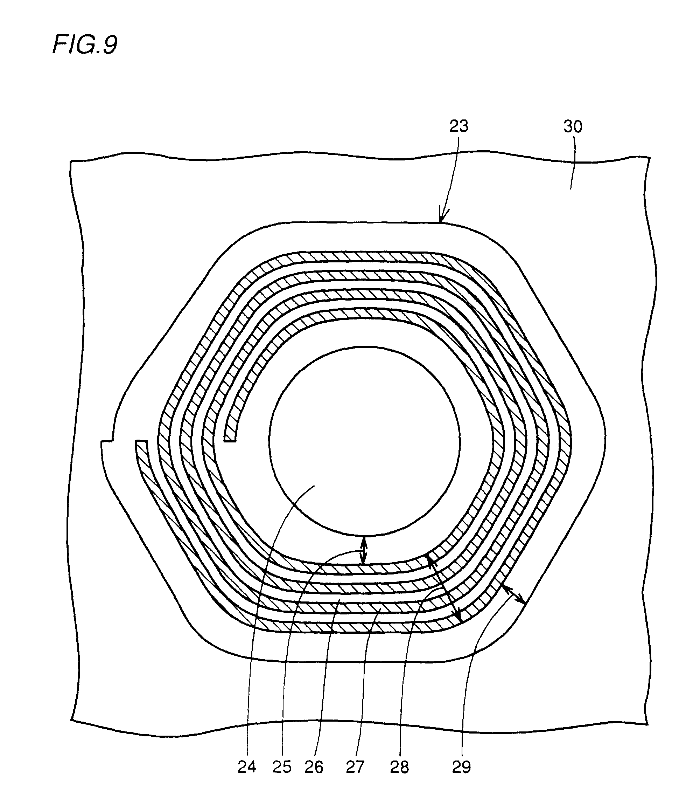

Fig. 9 is a model diagram of a microphotograph of 40 or 80 magnifications showing a section of each wire 23.

Referring to Fig. 9, the wire 23 was made up by a first diffusion barrier layer 25 containing Nb, which was formed to enclose the outer surface of a centrally located copper matrix (stabilizing material) 24, a laminate portion 28 which was formed to enclose the first diffusion barrier layer 25, and a second diffusion barrier layer 29 containing Nb, which was formed to enclose the laminate portion 28. Further, another copper matrix (stabilizing material) 30 was formed around the wire 23, to enclose the outer surface of the second diffusion barrier layer 29.

In this wire 23, Nb containing layers 26 and Al containing layers 27 were alternately spirally formed in the laminate portion 28. The interface between the Nb containing layers 26 and the Al containing layers 27 was smoothed.

### (Comparative Example 2)

The wire 21 of 1 mm in diameter obtained in comparative example 1 was further drawn to prepare a wire of 0.6 mm in diameter.

The wire as obtained had a sectional structure which was similar to that of the wire according to comparative example 1 shown in Fig. 9. However, Nb containing layers 26 and Al containing layers 27 were reduced in thickness as compared with the wire of comparative example 1 as a whole, since the amount of drawing was increased as compared with comparative example 1.

### (Comparative Example 3)

A wire 31 of 1 mm in diameter was prepared by employing a Nb - 1% Zr containing sheet in place of a Nb sheet. Other conditions were absolutely similar to those in comparative example 1, and hence redundant description is omitted.

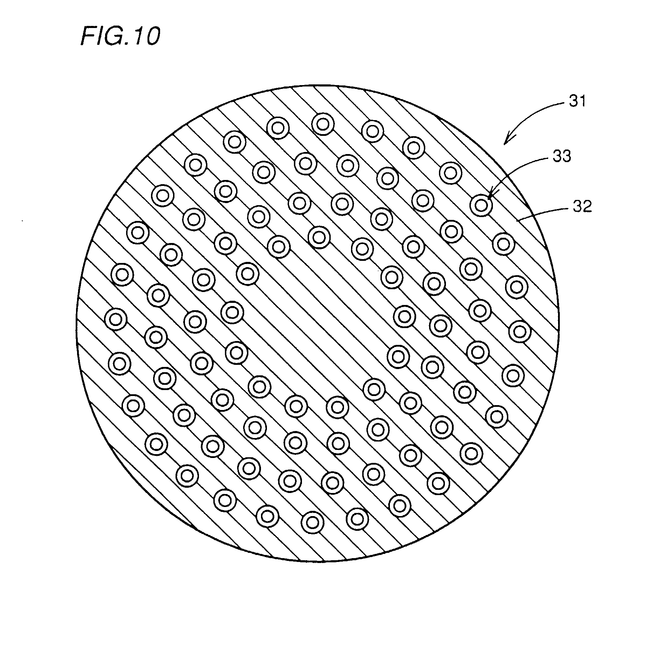

Fig. 10 is a sectional view schematically showing the wire 31 as obtained.

Referring to Fig. 10, this wire 31 was formed by a matrix (stabilizing material) 32 of Cu and a number of wires 33 consisting of Nb -1% Zr, Al and Cu, which were embedded therein.

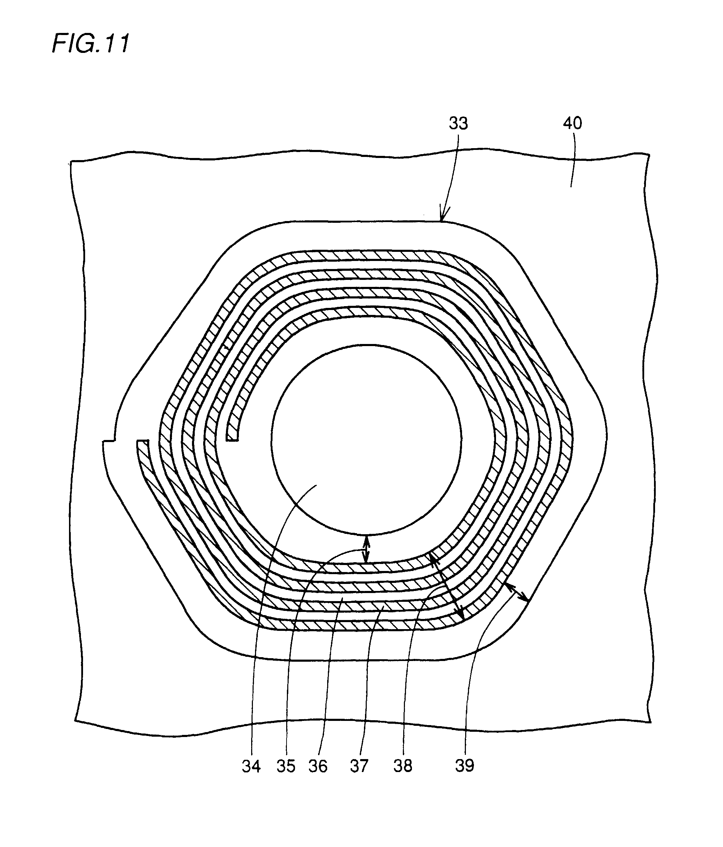

Fig. 11 is a model diagram of a microphotograph of 40 or 80 magnifications, showing a section of each wire 33.

Referring to Fig. 11, the wire 33 was made up by a first diffusion barrier layer 35 containing Nb, which was formed to enclose the outer surface of a centrally located copper matrix (stabilizing material) 34, a laminate portion 38 which was formed to enclose the first diffusion barrier layer 35, and a second diffusion barrier layer 39 containing Nb, which was formed to enclose the laminate portion 38. Further, another copper matrix (stabilizing material) 40 was formed around this wire 33, to enclose the outer surface of the second diffusion barrier layer 39.

In this wire 33, Nb layers 36 and Al layers 37 were alternately spirally formed in the laminate portion 38. The laminate portion 38 was further smoothly regularized as compared with comparative example 1.

### (Comparative Example 4)

The wire 31 of 1 mm in diameter obtained in comparative example 3 was further drawn to prepare a wire of 0.6 mm in diameter.

The wire as obtained had a sectional structure which was similar to that of the wire of comparative example 3 shown in Fig. 11. However, Nb layers 36 and Al layers 37 were smaller in thickness than those in the wire of comparative example 3 as a whole, since the amount of drawing was larger than that of comparative example 3.

### (Superconductivity Test)

The six types of wires obtained in Examples 1 and 2 and comparative examples 1 to 4 were heat treated at 800°C for 5 hours to prepare superconducting wires, which were then subjected to measurement of critical current densities (Jc) at 4.2 K and 12 T. Table 1 shows the results.

**Table 1**

| | First Sheet | | Wire Diameter | Critical Current Density Jc(12T) |
|---|---|---|---|---|
| | Material | Heat Treatment | | |
| Example 1 | Nb Foil | Yes | 1.0 mmφ | 350 A/mm² |
| Example 2 | Nb Foil | Yes | 0.6 mmφ | 450 A/mm² |
| Comparative Example 1 | Nb Foil | No | 1.0 mmφ | 250 A/mm² |
| Comparative Example 2 | Nb Foil | No | 0.6 mmφ | 350 A/mm² |
| Comparative Example 3 | Nb 1% Zr | No | 1.0 mmφ | 180 A/mm² |
| Comparative Example 4 | Nb 1% Zr | No | 0.6 mmφ | 230 A/mm² |

As clearly understood from Table 1, the wires according to Examples, which were identical in wire diameter to those of comparative examples, attained higher critical current densities (Jc) since the interfaces between the Nb containing layers and Al containing layers were densely zigzagged to increase the contact areas between these layers.

Comparing Examples 1 and 2 with each other, a higher critical current density (Jc) was attained with a larger amount of drawing in advance of the heat treatment.

The metal atoms X for reacting with Nb and forming a compound exhibiting superconductivity can be prepared from Sn or Ge, for example, in place of Al employed in the aforementioned Examples. Further, an Nb alloy and/or an alloy containing the metal atoms X may further contain Ge, Sn, Ti, Si, Hf, Ta, Zr, Mg, Be or the like, for example.

The step of heat treating a first sheet of pure Nb or Nb alloy is preferably carried out in a temperature range of 700 to 1100°C for 1 to 10 hours, more preferably for about 2 hours. A temperature range of less than 700°C is insufficient for readjusting the grain structure and forming a first sheet having irregular grain orientations. On the other hand, a heat treatment which is carried out in the temperature range of 700 to 1100°C for a time of less than 1 hour is insufficient for readjusting the grain structure and forming a first sheet having irregular grain orientations, while that exceeding 10 hours is unpreferable since Nb grains are made coarse in grain size to make the first sheet brittle.

Further, heat treatment (annealing) conditions for the first sheet are varied with composition homogeneity of an ingot of pure Nb or Nb alloy before rolling, the content of impurities, working hysteresis and the like. When a high-quality ingot having excellent composition homogeneity and a small content of impurities was employed, it was possible to anneal the same by a lowtemperature heat treatment while a heat treatment temperature increasing grain sizes tended to decrease. When the first sheet is prepared from a high-quality material, therefore, it is possible to sufficiently attain the effect of the present invention by performing the heat treatment at 700 to 800°C for about 2 hours. Further, this heat treatment step is preferably carried out at a degree of vacuum of about 1,3 · 10⁻³ to 1,3 · 10⁻⁵ Pa (10⁻⁵ to 10⁻⁷ Torr).

Although the present invention has been described and illustrated in detail, it is clearly understood that the same is by way of illustration and example only and is not to be taken by way of limitation, the scope of the present invention being limited only by the terms of the appended claims.

## Claims

1. A method of preparing a Nb₃X superconducting wire, said method comprising the steps of:
preparing a first sheet (1; 16) consisting of pure Nb or an Nb alloy by melting and rolling;
said method further comprising
heat treating said first sheet (1; 16) consisting of pure Nb or Nb alloy;
superposing and winding up said heat treated first sheet (1; 16) and a second sheet (2; 17) consisting of metal atoms X or an alloy of X each reacting with said Nb and forming a compound exhibiting superconductivity thereby preparing a wire (4); and
performing working on said wire (4) for reducing its sectional area.

2. A method of preparing a Nb₃X superconducting wire, characterized by
a step of bundling a plurality of wires (9) as defined in claim 1 being subjected to said working and charging the same in a cylindrical member (10); and
further performing working on said cylindrical member (10) being charged with said wires (9) for reducing its sectional area, thereby preparing a multifilamentary wire (11).

3. A method of preparing an Nb₃X superconducting wire as defined in claim 1, characterized by further comprising:
a step of heat treating said wire (9) being subjected to said working.

4. A method of preparing an Nb₃X superconducting wire as defined in claim 2, characterized by further comprising:
a step of heat treating said multifilamentary wire (11) being subjected to said working.

5. A method of preparing an Nb₃X superconducting wire in accordance with claim 1, 2, 3 or 4, wherein said step of heat treating said first sheet (1; 16) is carried out in and for a temperature range and a time being sufficient for readjusting the crystal structure of said first sheet (1; 16) and irregularizing crystal orientations.

6. A method of preparing an Nb₃X superconducting wire in accordance with claim 1, 2, 3 or 4, wherein said step of heat treating said first sheet (1; 16) is carried out in a temperature range of 700 to 1100°C for 1 to 10 hours.

## Patentansprüche

1. Ein Verfahren zum Herstellen eines supraleitenden Nb₃X-Drahtes, wobei das Verfahren die Schritte aufweist:
Herstellen eines ersten Bleches (1; 16), das aus reinem Nb oder einer Nb-Legierung besteht, mittels Schmelzen und Walzen;
wobei das Verfahren des weiteren aufweist:
Wärmebehandeln des ersten Bleches (1; 16), das aus reinem Nb oder einer Nb-Legierung besteht;
Übereinanderlegen und Aufwickeln des wärmebehandelten ersten Bleches (1; 16) und eines zweiten Bleches (2; 17), das aus Metallatomen X oder einer Legierung aus X besteht, die jeweils mit dem Nb reagieren und eine Verbindung bilden, die Supraleitfähigkeit zeigt, wodurch ein Draht (4) hergestellt wird; und
Durchführen von Bearbeitung an dem Draht (4) zum Verringern seiner Querschnittsfläche.

2. Ein Verfahren zum Herstellen eines supraleitenden Nb₃X-Drahtes, gekennzeichnet durch
einen Schritt des Bündelns einer Vielzahl von wie in Anspruch 1 definierten und der Bearbeitung unterworfenen Drähten (9) und des Füllens derselben in ein zylindrisches Teil (10), und
weiteres Durchführen von Bearbeitung an dem zylindrischen Teil (10), das mit dem Drähten (9) gefüllt ist, zum Verringern seiner Querschnittsfläche, wodurch ein Multifilamentdraht (11) hergestellt wird.

3. Ein Verfahren zum Herstellen eines supraleitenden Nb₃X-Drahtes wie in Anspruch 1 definiert, dadurch gekennzeichnet, daß es des weiteren aufweist:
einen Schritt des Wärmebehandelns des der Bearbeitung unterworfenen Drahtes (9).

4. Ein Verfahren zum Herstellen eines supraleitenden Nb₃X-Drahtes wie in Anspruch 2 definiert, dadurch gekennzeichnet, daß es des weiteren aufweist:
einen Schritt des Wärmebehandelns des der Bearbeitung unterworfenen Multifilamentdrahtes (11).

5. Ein Verfahren zum Herstellen eines supraleitenden Nb₃X-Drahtes gemäß Anspruch 1, 2, 3 oder 4, worin der Schritt des Wärmebehandelns des ersten Bleches (1; 16) ausgeführt wird in und für einen Temperaturbereich und eine Zeit, die hinreichend zum Neuordnen der Kristallstruktur des ersten Bleches (1; 16) und Unregelmäßigmachen der Kristallorientierungen sind.

6. Ein Verfahren zum Herstellen eines supraleitenden Nb₃X-Drahtes gemäß Anspruch 1, 2, 3 oder 4, worin der Schritt des Wärmebehandelns des ersten Bleches (1; 16) in einem Temperaturbereich von 700 bis 1100°C für 1 bis 10 Stunden durchgeführt wird.

## Revendications

1. Procédé de préparation d'un fil supraconducteur en Nb3X, ledit procédé comprenant les étapes de :
préparation d'une première feuille (1 ; 16) consistant en Nb pur ou en un alliage de Nb par fusion et laminage ;
ledit procédé comprenant en outre
le traitement thermique de ladite première feuille (1 ; 16) consistant en Nb pur ou en un alliage de Nb ;
la superposition et l'enroulement de ladite première feuille traitée thermiquement (1; 16) et d'une seconde feuille (2 ; 17) consistant en atomes métalliques X ou en un alliage de X réagissant chacun avec ledit Nb et formant un composé présentant une supraconductivité, pour préparer ainsi un fil (4) ; et
la mise en oeuvre d'une transformation sur ledit fil (4) pour réduire son aire en section droite.

2. Procédé de préparation d'un fil supraconducteur en Nb3X, caractérisé par :
une étape de réunion en faisceau d'une pluralité de fils (9) selon la revendication 1 soumis à ladite transformation et leur introduction dans un élément cylindrique (10) ; et
la mise en oeuvre d'une transformation sur ledit élément cylindrique (10) contenant lesdits fils (9) pour réduire son aire en section droite, pour préparer ainsi un fil multifilarnent (11).

3. Procédé de préparation d'un fil supraconducteur en Nb₃X selon la revendication 1, caractérisé en ce qu'il comprend en outre :
une étape de traitement thermique dudit fil (9) qui est soumis à ladite transformation.

4. Procédé de préparation d'un fil supraconducteur en Nb₃X selon la revendication 2, caractérisé en ce qu'il comprend en outre :
une étape de traitement thermique dudit fil multifilarnent (11) qui est soumis à ladite transformation.

5. Procédé de préparation d'un fil supraconducteur en Nb₃X selon la revendication 1, 2, 3 ou 4 dans lequel ladite étape de traitement thermique de ladite première feuille (1 ; 16) est réalisée dans un domaine de température et pendant une durée suffisants pour réajuster la structure cristalline de ladite première feuille (1 ; 16) et pour rendre irrégulières les orientations cristallines.

6. Procédé de préparation d'un fil supraconducteur en Nb₃X selon la revendication 1, 2, 3 ou 4 dans lequel ladite étape de traitement thermique de ladite première feuille (1; 16) est réalisée dans un domaine de température de 700 à 1100°C pendant 1 à 10 h.
